# EUROPÄISCHE PATENTSCHRIFT

(11) **EP 1 094 607 B1**
(45) Veröffentlichungstag und Bekanntmachung des Hinweises auf die Patenterteilung: **06.12.2006**
(21) Anmeldenummer: 99120073.4
(22) Anmeldetag: 20.10.1999
(51) Int. Cl.: H03K 19/173, G11C 16/04, H01L 29/788

(54) **Programmierbare FPGA-Zelle**
Programmable cell for FPGA
Cellule programmable pour circuit FPGA

(43) Veröffentlichungstag der Anmeldung: 25.04.2001
(73) Patentinhaber: Infineon Technologies AG, 81669 München (DE)
(72) Erfinder: Ludwig, Christoph, Dr., 01465 Langebrück (DE); Kutter, Christoph, Dr., 01099 Dresden (DE); Wolf, Konrad, Dr., 83624 Otterfing (DE); Heitzsch, Olaf, 01640 Coswig (DE); Huckels, Kai, 01465 Langebrück (DE); Rennekamp, Reinhold, 01099 Dresden (DE); Röhrich, Mayk, 01099 Dresden (DE); Stein von Kamienski, Elard, Dr., 01099 Dresden (DE); Wawer, Peter, Dr., 01309 Dresden (DE); Springmann, Oliver, 01109 Dresden (DE)
(74) Vertreter: Kindermann, Peter

(56) Entgegenhaltungen:
- DE-A- 19 813 653
- US-A- 5 633 518
- US-A- 5 773 862
- TSUJI N ET AL: "NEW ERASE SCHEME FOR DINOR FLASH MEMORY ENHANCING ERASE/WRITE CYCLING ENDURANCE CHARACTERISTICS" TECHNICAL DIGEST OF THE INTERNATIONAL ELECTRON DEVICES MEETING,US,NEW YORK, IEEE, Bd. MEETING 40, 1994, Seiten 53-56, XP000585436 ISBN: 0-7803-2112-X
- ANONYMOUS: "Dense Hot Electron Programmable Memory. March 1981." IBM TECHNICAL DISCLOSURE BULLETIN, Bd. 23, Nr. 10, 1. März 1981 (1981-03-01), Seiten 4458-4460, XP002138463 New York, US

## Beschreibung

Die vorliegende Erfindung bezieht sich auf eine FPGA-Zelle und insbesondere auf eine FPGA-Zelle mit integriertem nichtflüchtigen Halbleiterspeicherelement.

FPGAs (field programmable gate arrays) bzw. anwenderprogrammierbare Verknüpfungsfelder weisen üblicherweise ein Feld von Logikelementen und einen Verdrahtungsabschnitt auf, der aus mehreren tausend oder sogar hunderttausenden von programmierbaren Verbindungen besteht, wodurch das FPGA von einem Anwender als integrierte Schaltung mit definierten Funktionen programmiert werden kann. Jede programmierbare Verbindung kann hierbei als FPGA-Zelle eine Vielzahl von Schaltungsknoten der integrierten Schaltung verbinden oder unterbrechen, wodurch Funktionen von Logikelementen des FPGAs anwenderspezifisch eingestellt werden können.

Im wesentlichen sind FPGAs mit flüchtigen (SRAMs) oder nichtflüchtigen Halbleiterspeicherelementen wie z.B. Flash oder mit sogenannten "Antifuses" als FPGA-Zellen bekannt. Bei "Antifuses" wird durch Anlegen einer hohen Spannung eine isolierende Schicht zerstört und dadurch eine leitende Verbindung hergestellt, weshalb sie nur ein einziges Mal programmiert werden können. Im Gegensatz dazu können Flash-basierte FPGAs mehrfach programmiert werden. Die vorliegende Erfindung bezieht sich ausschließlich auf FPGA-Zellen mit nichtflüchtigen Halbleiterspeicherelementen.

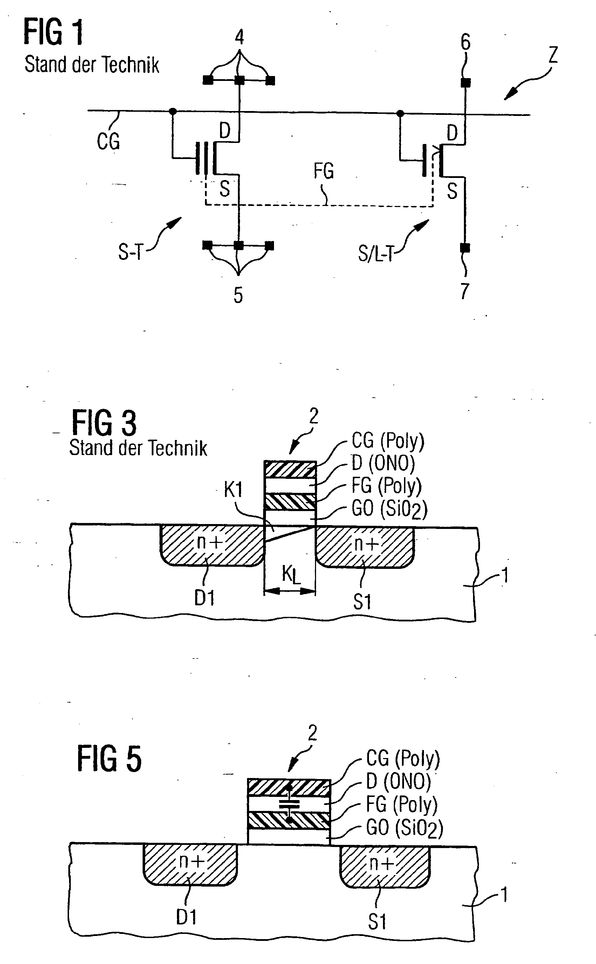

Figur 1 zeigt ein elektrisches Ersatzschaltbild einer herkömmlichen FPGA-Zelle Z wie sie beispielsweise aus der Druckschrift DE 198 13 653 A1 bekannt ist. Gemäß Figur 1 besteht die FPGA-Zelle im wesentlichen aus einem Schalt-Transistor (S-T) und einem Schreib/Lese-Transistor (S/L-T). Der Schalt-Transistor S-T dient hierbei dem Herstellen einer Verbindung oder Unterbrechung zwischen Anschlußpunkten 4 und Anschlußpunkten 5. Die Anschlußpunkte 4 und 5 können hierbei mit Schaltungsknoten der Logikelemente verbunden sein und diese in Abhängigkeit vom Zustand des Schalt-Transistors S-T miteinander verbinden oder voneinander trennen, wodurch die Funktionen des FPGAs anwenderspezifisch eingestellt werden können.

Gemäß Figur 1 besteht der Schalt-Transistor S-T aus einem Feldeffekttransistor mit einer ladungsspeichernden Schicht FG, die ihn mit dem Schreib/Lese-Transistor S/L-T verbindet. Der Schreib/Lese-Transistor S/L-T dient dem Programmieren der FPGA-Zelle Z und insbesondere dem Schreiben und Lesen von Informationen über die Anschlußpunkte 6 und 7 bzw. dazugehörige Drain/Source-Gebiete D und S. Genauer gesagt werden zur Speicherung von Informationen Ladungen von einem in einem Halbleitersubstrat ausgebildeten Kanalbereich über eine Tunneloxidschicht in die ladungsspeichernde Schicht FG eingebracht, wobei beispielsweise Injektion heißer Ladungsträger, Kanalinjektion und/oder Fowler-Nordheim-Tunneln angewendet wird. Die auf diese Weise in die ladungsspeichernde Schicht FG des Schreib/Lese-Transistors S/L-T eingebrachten Ladungen liegen aufgrund der durchgehenden Verbindung auch am Schalt-Transistor S-T an, wodurch dieser in seinem Schaltverhalten über den Schreib/Lese-Transistor S/L-T programmiert werden kann.

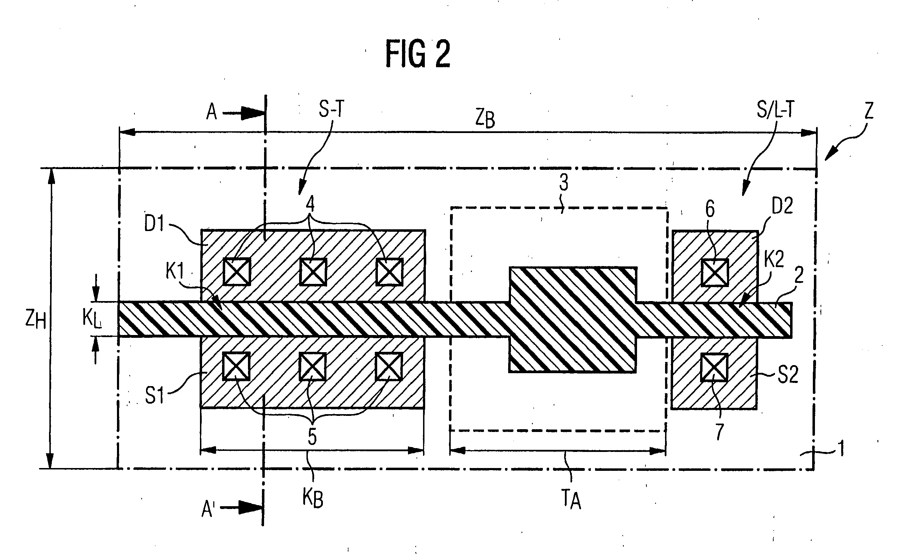

Figur 2 zeigt eine schematische Draufsicht eines tatsächlichen Layouts einer derartigen herkömmlichen FPGA-Zelle Z. Die FPGA-Zelle Z besitzt eine Zellenbreite Z_{B} und eine Zellenhöhe Z_{H}, wobei mehrere tausende oder sogar hunderttausende dieser FPGA-Zellen ein FPGA (field programmable gate array) bzw. ein anwenderprogrammierbares Verknüpfungsfeld realisieren.

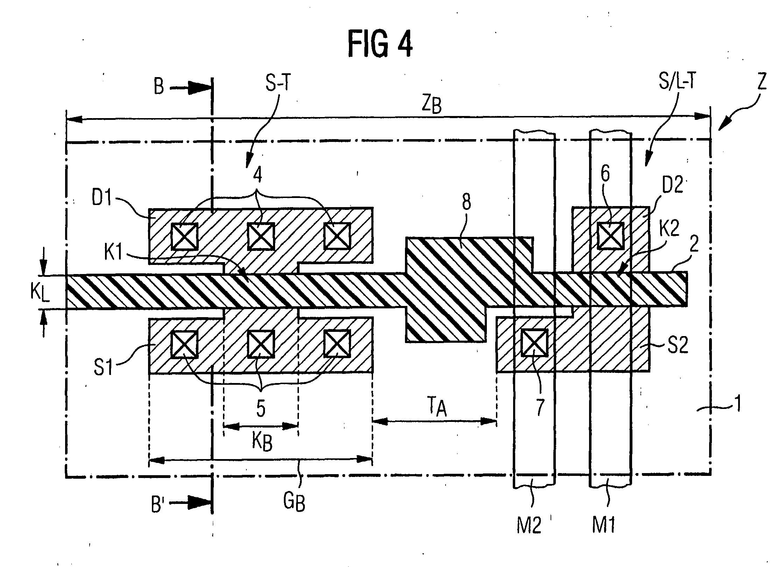

Figur 3 zeigt hierbei eine vereinfachte Schnittansicht entlang eines Schnitts A-A' gemäß Figur 2. Zur Realisierung des Schalt-Transistors S-T besitzt die FPGA-Zelle Z jeweilige Drain/Source-Gebiete D1 und S1, die in einem Halbleitersubstrat 1 voneinander beabstandet beispielsweise mittels Diffusion oder Implantation ausgebildet sind. Gemäß Figuren 2 und 3 handelt es sich hierbei um n⁺-Diffusionsgebiete, die in einer p-Wanne oder einem p-dotierten Halbleitersubstrat 1 ausgebildet sind. Zum elektrischen Verbinden der vorstehend beschriebenen Schaltungsknoten besitzen diese Drain/Source-Gebiete D1 und S1 eine Vielzahl von Kontaktanschlüssen 4 und 5, die mit den Drain/Source-Gebieten D1 und S1 des Schalt-Transistors S-T elektrisch in Verbindung stehen.

Zwischen dem Drain/Source-Gebiet D1 und S1 des Schalt-Transistors S-T befindet sich an der Oberfläche des Halbleitersubstrats 1 eine Steuerschichtstruktur (2), die beispielsweise aus einer ersten Isolierschicht GO, aus einer ladungsspeichernden Schicht FG, aus einer zweiten Isolierschicht D und einer Steuerschicht CG besteht. Vorzugsweise besteht die erste Isolierschicht als Gateoxid-Schicht aus SiO₂, während die ladungsspeichernde Schicht FG als Floating-Gate-Schicht Polysilizium oder eine andere ladungsspeichernde Struktur aufweist. Für die darüber liegende zweite Isolierschicht D wird üblicher weise eine ONO-Schichtenfolge (Oxid/Nitrid/Oxid) und für die Steuerschicht CG wiederum Polysilizium oder eine andere elektrisch leitende Struktur verwendet. Auf diese Weise erhält man einen Schalt-Transistor S-T mit einer Kanalbreite K_{B} und einer Kanallänge KL, dessen Schaltverhalten abhängig von den in der ladungsspeichernden Schicht FG gespeichertem Ladungen ist.

Zum Einbringen der Ladungen in die ladungsspeichernde Schicht FG befindet sich im Abstand TA ein weiteres Drain/Source-Gebiet D2 und S2 im Halbleitersubstrat 1 zum Ausbilden des Schreib/Lese-Transistors S/L-T. Der Schreib/Lese-Transistor S/L-T besitzt im wesentlichen einen ähnlichen Aufbau wie der Schalt-Transistor S-T, wobei er jedoch derart dimensioniert ist bzw. angesteuert werden kann, daß Ladungen beispielsweise mittels Injektion heißer Ladungsträger, Kanalinjektion oder Fowler-Nordheim-Tunneln in die erste leitende Schicht (FG) eingebracht werden können. Zum Anlegen der Schreib/Lese-Spannungen besitzt das zweite Drain/Source-Gebiet des Schreib/Lese-Transistors S/L-T Kontaktanschlüsse 6 und 7. Die Steuerschichtstruktur 2 des Schalt-Transistors S-T und des Schreib/Lese-Transistors S/L-T ist hierbei durchgehend ausgebildet und verbindet die jeweiligen Transistoren miteinander. Auf diese Weise kann eine über den Schreib/Lese-Transistor S/L-T eingebrachte Ladung in die erste leitende Schicht FG ein Schaltverhalten des Schalt-Transistors S-T verändern. Zum Isolieren des Schalt-Transistors vom Schreib/Lese-Transistor innerhalb des Halbleitersubstrats 1 befindet sich im Abstandsbereich mit der Breite T_{A} ein Isoliergebiet 3, welches beispielsweise als Diffusionsgebiet mit entgegengesetzter Dotierung zum Drain/Source-Gebiet ausgebildet ist. Gemäß Figuren 2 und 3 besitzt dieses Isoliergebiet 3 beispielsweise eine p-Dotierung. Zur Verbesserung eines Kopplungsfaktors besitzt die Steuerschichtstruktur 2 oberhalb dieses Isoliergebiets 3 eine Verbreiterung bzw. Flächenvergrößerung, wodurch die Schreib/Lese-Spannungen für die FPGA-Zelle Z verringert werden können.

Der Platzbedarf sowie die Einsatzspannungen zum Programmieren einer derartigen herkömmlichen FPGA-Zelle sind jedoch immer noch relativ groß, was sich insbesondere bei einer Anordnung von mehreren tausend oder sogar hunderttausend derartiger Zellen in einem FPGA negativ auf die Gesamtfläche sowie - performance auswirkt.

Aus dem "Technical Digest of the International Electron Devices Meeting, US, New York, IEEE (1994), Meeting 40, Seiten 53 bis 56, "New erase scheme for DINOR flash memory enhancing erase/write cycling endurance characteristics", N.Tsuji, u.a.", ist eine NOR-Speicherzelle bekannt, die einen Transistor mit einem sogenannten Floating-Gate enthält. Zum Programmieren der Zelle wird der Fowler-Nordheim-Tunneleffekt ausgenutzt. Zum Löschen der Speicherzelle werden vom Substrat kommende schnelle Elektronen verwendet (SHE - Substrate Hot Electron). Um Materialermüdungen voneinander zu trennen, die durch die gegenseitige Beeinflussung von Löschvorgängen und Schreibvorgängen entstehen, wurde eine Zelle mit zwei Transistoren verwendet, die ein gemeinsames Floating-Gate und einen gemeinsamen Steueranschluss, jedoch voneinander unabhängige aktive Gebiete haben.

Aus der DE 198 13 653 A 1 ist ein anwenderprogrammierbares Verknüpfungsfeld bekannt, das eine Vielzahl von FPGA-Zellen enthält. Eine FPGA-Zelle enthält jeweils einen Schalt-Transistor und einen Schreib/Lese-Transistor. Eine gemeinsame Steuerschichtstruktur weist zum gemeinsamen Ansteuern der beiden Transistoren über den jeweiligen Kanalgebieten eine erste Isolierschicht, eine ladungsspeichernde Schicht und eine zweite Isolierschicht sowie eine Steuerschicht auf. Außerdem gibt es ein Isoliergebiet zum Isolieren der beiden Transistoren einer FPGA-Zelle.

Der Erfindung liegt daher die Aufgabe zugrunde, eine FPGA-Zelle der eingangs genannten Art derart weiterzubilden, daß sich ein weiter verringerter Platzbedarf und verbesserte Einsatzspannungen zum Programmieren der FPGA-Zelle ergeben.

Erfindungsgemäß wird diese Aufgabe durch die Merkmale des Patentanspruchs 1 gelöst.

Insbesondere durch die Verwendung eines Schalt-Transistors, dessen Kanalbreite kleiner ist als eine Gesamtbreite der dazugehörigen Drain/Source-Gebiete kann ein Kopplungsfaktor wesentlich verbessert werden, wodurch sich die Einsatzspannungen für das Programmieren mittels des Schreib/Lese-Transistors stark verringern. Gleichzeitig kann die Zellbreite der FPGA-Zelle verringert werden, da ein aktiver Kanal des Schalt-Transistors bei gleichem Isolationsabstand vom Schreib/Lese-Transistor derart angeordnet ist, daß sich die Zellbreite der FPGA-Zelle wesentlich verringert.

Vorzugsweise wird das zweite Drain/Source-Gebiet des Schreib/Lese-Transistors L-förmig ausgebildet, wodurch sich eine weitere Platzoptimierung bei einer anschließenden Metallisierung ergibt.

In den weiteren abhängigen Ansprüchen sind weitere vorteilhafte Ausgestaltungen der Erfindung gekennzeichnet.

Die Erfindung wird nachstehend anhand eines Ausführungsbeispiels unter Bezugnahme auf die Zeichnung näher beschrieben.

Es zeigen:
- Figur 1: ein elektrisches Ersatzschaltbild einer FPGA-Zelle gemäß dem Stand der Technik;
- Figur 2: eine schematische Draufsicht eines Layouts der FPGA-Zelle gemäß dem Stand der Technik nach Figur 1;
- Figur 3: eine vereinfachte Schnittansicht der FPGA-Zelle gemäß Figur 2 entlang eines Schnitts A-A';
- Figur 4: eine schematische Draufsicht der wesentlichen Elemente eines Layouts einer erfindungsgemäßen FPGA-Zelle; und
- Figur 5: eine vereinfachte Schnittansicht der FPGA-Zelle gemäß Figur 4 entlang eines Schnitts B-B'.

Ein wesentliches Merkmal von FPGA-Zellen mit nichtflüchtiger Halbleiterspeicherstruktur ist neben dem Platzbedarf pro FPGA-Zelle der Kopplungsfaktor, der ein Verhältnis der Spannungen in der ersten und zweiten leitenden Schicht der Steuerschichtstruktur angibt.

Der Kopplungsfaktor wird hierbei durch die Kapazitäten C_{CG-FG} (Steuerschicht CG zu ladungsspeichernder Schicht FG) und C_{FG-Substrat} (ladungsspeichernde Schicht FG zu Substrat) bestimmt. Je größer dieses Verhältnis der Kapazität zwischen Steuerschicht CG und ladungsspeichernder Schicht FG sowie der Kapazität zwischen Steuerschicht CG und Halbleitersubstrat 1, desto günstiger wirkt sich diese auf die Programmierung des FPGA's aus. Genauer gesagt verkürzen sich mit verbessertem Kopplungsfaktor die Programmierzeiten (Schreib/Lese-Zeiten) im Schreib/Lese-Transistor, wobei darüber hinaus geringere Spannungen für das Programmieren und Löschen ausreichen. Kürzere Zeiten sind hierbei ein wichtiger Marketingvorteil bei der Vermarktung von FPGAs, während sich niedrigere Spannungen zum einen in einem geringeren Platzbedarf auf dem Baustein niederschlagen und zum weiteren die Anforderungen an eine Energieversorgung verringern.

Figur 4 zeigt eine schematische Draufsicht der wesentlichen Elemente einer erfindungsgemäßen FPGA-Zelle Z mit verbessertem Kopplungsfaktor und verringertem Platzbedarf. Gleiche Bezugszeichen bezeichnen gleiche oder ähnliche Komponenten bzw. Bauteile wie in Figur 2, weshalb auf eine detaillierte Beschreibung nachfolgend verzichtet wird.

Ein elektrisches Ersatzschaltbild der FPGA-Zelle entspricht dem in Figur 1 dargestellten Ersatzschaltbild, weshalb auf eine wiederholte Beschreibung nachfolgend verzichtet wird.
Die erfindungsgemäße FPGA-Zelle Z besteht gemäß Figur 4 wiederum aus einem Schalt-Transistor S-T und einem Schreib/Lese-Transistor S/L-T. Der Schalt-Transistor und der Schreib/Lese-Transistor sind über eine Steuerschichtstruktur 2 miteinander verbunden, die im wesentlichen aus einer ersten Isolierschicht GO, einer ladungsspeichernden Schicht FG, einer zweiten Isolierschicht D sowie einer Steuerschicht CG besteht und an der Oberfläche eines Halbleitersubstrats 1 stapelförmig ausgebildet ist. Das Halbleitersubstrat 1 besteht vorzugsweise aus Si, SiGe, SiC, SOI, GaAs oder einem sonstigen III-V-Halbleiter. Das Abscheiden der einzelnen Schichten der Steuerschichtstruktur 2 wird vorzugsweise in einem SPUTTER-Verfahren durchgeführt wobei jedoch auch alle weiteren herkömmlichen Herstellungsverfahren verwendet werden können.

Vorzugsweise wird die erste Isolierschicht GO als Gate-Oxid-Schicht im Schalt-Transistor S-T bzw. als Tunnel-Oxid-Schicht im Schreib/Lese-Transistor S/L-T mittels eines Oxidationsverfahrens zum Ausbilden einer SiO₂-Schicht realisiert. Die ladungsspeichernde Schicht FG (floating gate) dient dem Speichern von Ladungen und besteht vorzugsweise aus abgeschiedenem Polysilizium oder einer sonstigen ladungsspeichernden Struktur. Zur Isolation von der Steuerschicht CG (control gate), die vorzugsweise aus Polysilizium oder Metall ausgebildet ist, befindet sich eine zweite Isolierschicht D zwischen ladungsspeichernde Schicht FG und Steuerschicht CG. Üblicherweise besteht eine derartige zweite Isolierschicht aus einer Schichtenfolge von Oxid/Nitrid/Oxid, weshalb sie als ONO-Schicht bezeichnet wird.

Die wesentliche Verbesserung des Layouts gemäß Figur 4 gegenüber dem Layout gemäß Figur 2 besteht nunmehr darin, daß eine effektive Kanalbreite K_{B} eines Kanalgebiets K1 des Schalt-Transistors S-T derart verringert bzw. verkürzt ist, daß sie kleiner als eine Gesamtbreite G_{B} des dazugehörigen Drain/Source-Gebiets D1 und S1 des Schalt-Transistors S-T ist. Eine derartige Verkürzung der Kanalbreite K_{B} erhält man beispielsweise durch eine Dimensionierung der Drain/Source-Gebiete D1 und S1 des Schalt-Transistors S-T gemäß Figur 4, wobei lediglich ein Teil dieser Drain/Source-Gebiete D1 und S1 im Halbleitersubstrat 1 unmittelbar an die Steuerschichtstruktur 2 des Schalt-Transistors S-T heranreicht. Der größere Teil ist jedoch gemäß Figur 4 von der Steuerschichtstruktur 2 beabstandet und bildet somit kein effektives Kanalgebiet für den Schalt-Transistor S-T.

Gemäß Figur 4 besitzt ein derartiges Drain/Source-Gebiet D1 und S1 des Schalt-Transistor S-T gemeinsam im wesentlichen eine H-Form, wobei die Steuerschichtstruktur 2 die H-Form von unten nach oben durchquert.

Die Folge einer derartigen Verringerung der Kanalbreite K_{B} des Kanalgebiets des Schalt-Transistor S-T führt zu einer Verbesserung des Kopplungsfaktors sowie einer Verringerung des Platzbedarfs für die FPGA-Zelle Z, was nachfolgend im einzelnen beschrieben wird.

Figur 5 zeigt eine Schnittansicht der FPGA-Zelle Z gemäß Figur 4 entlang eines Schnitts B-B'.

Gemäß Figur 5 reichen - im Gegensatz zur herkömmlichen FPGA-Zelle gemäß Figur 2 - die Drain/Source-Gebiete D1 und S1 in einem weiten Bereich nicht mehr bis an die Steuerschichtstruktr 2 heran, weshalb in diesen Bereichen unterhalb der Steuerschichtstruktur 2 kein wirksames Kanalgebiet zwischen den Drain/Source-Gebieten D1 und S1 ausgebildet wird. Gemäß Figur 4 besitzt der Schalt-Transistor S-T lediglich ein Kanalgebiet K1 in seinem mittleren Bereich, an dem die Drain/Source-Gebiete D1 und S1 unmittelbar an die Steuerschichtstruktur 2 heranreichen.

Gemäß Figur 5 bedeutet dies, daß eine Kapazität C'_{FG-Substrat} zwischen der ladungsspeichernden Schicht FG und dem Halbleitersubstrat 1 in diesem Bereich im wesentlichen entfällt, da weder ein Kanalgebiet noch Drain/Source-Gebiete unmittelbar vorhanden sind. Aufgrund der Verringerung dieser Kapazität C'_{FG-Substrat} zwischen der ladungsspeichernden Schicht FG und dem Halbleitersubstrat 1 in den jeweiligen Bereichen ergibt sich für die FPGA-Zelle gemäß Figur 4 eine deutliche Verringerung für die Gesamtkapazität C_{FG-Substrat} zwischen der ladungsspeichernden Schicht FG und dem gesamten Halbleitersubstrat 1. Demzufolge ergibt sich dadurch eine Verbesserung des Kopplungsfaktors, wobei ein Kopplungsfaktor von 0,6 für die herkömmliche FPGA-Zelle gemäß Figur 2 auf einen Kopplungsfaktor von 0,7 für die erfindungsgemäße FPGA-Zelle Z gemäß Figur 4 erreicht werden kann.

Ferner ergeben sich dadurch kürzere Programmierzeiten (Schreib/Lese-Zeiten) für den Schreib/Lese-TransistorS/L-T, wobei ein Platzbedarf für einen Baustein aufgrund der geringeren Anforderungen an die spannungserzeugenden Schaltungsteile verringert wird.

Es ergibt sich jedoch auch eine Optimierung des Platzbedarfs für die jeweilige FPGA-Zelle Z, da ein notwendiger Isolierabstand T_{A} zwischen dem Schalt-Transistor S-T und dem Schreib/Lese-Transistor S/L-T wesentlich verringert werden kann.

Wesentlich für den Isolierabstand T_{A} und ein darin liegendes Isoliergebiet 3 ist insbesondere der Abstand der aktiven Kanalgebiete des Schalt-Transistors S-T und des Schreib/Lese-Transistors S/L-T. Aufgrund der Tatsache, daß das effektive Kanalgebiet K1 des Schalt-Transistors zurückversetzt ist, können die Drain/Source-Gebiete D1 und S1 sowie D2 und S2 der jeweiligen Transistoren S-T und S/L-T näher zusammenrücken, ohne dabei Latch-up-Effekte oder sonstige Leckströme zu verursachen. Die Zellbreite Z_{B} der FPGA-Zelle Z kann somit deutlich verringert werden, wobei eine Anschlußfläche für die Anschlußelemente 4 und 5 in den Drain/Source-Gebieten D1 und S1 des Schalt-Transistors S-T unverändert erhalten bleibt.

Darüber hinaus besitzt der Schalt-Transistor S-T entgegen erster Vermutungen auch keine Einbußen hinsichtlich seiner Performance. Genauer gesagt wäre zu erwarten, daß eine Verringerung der Kanalbreite K_{B} und eine damit einhergehende Verringerung der Stromschaltfähigkeit eine wesentliche Verschlechterung des Schalt-Transistors S-T hervorruft. Es zeigt sich jedoch, daß insbesondere bei schnellen Schaltvorgängen ein Energieverbrauch und somit eine Verlustleistung bei einem in Figur 4 dargestellten Layout für den Schalt-Transistor S-T verringert ist, wodurch sich im wesentlichen eine Kompensation dieses Nachteils ergibt.

Zur weiteren Optimierung des Platzbedarfs der FPGA-Zelle Z kann das Drain/Source-Gebiet D2 und S2 des Schreib/Lese-Transistors S/L-T gemeinsam im wesentlichen L-förmig ausgebildet sein, wobei sich die Kontaktanschlüsse 6 und 7 an ihren distalen Enden der Gebiete befinden. Bei einem derartigen Layout für das Drain/Source-Gebiet D2 und S2 des Schreib/Lese-Transistor S/L-T kann eine nachfolgend aufgebrachte Metallisierung M1 und M2 für die jeweiligen Kontaktanschlüsse 6 und 7 im wesentlichen streifenförmig bzw. geradlinig ausgebildet werden, wodurch sich eine Vereinfachung der Metallisierungsmaske(n) ergibt.

Darüber hinaus kann durch eine den Drain/Source-Gebieten D1, S1, D2 und S2 angepaßte_flächenmäßig unsymmetrische Vergrößerung 8 der Steuerschichtstruktur 2 (Vergrößerung der Kapazität C_{CG-FG}) eine weitere Verbesserung des Kopplungsfaktors erreicht werden, ohne dabei den Platzbedarf für die FPGA-Zelle Z negativ zu beeinflussen. Zur Verbesserung des Kopplungsfaktors kann ferner für die zweite Isolierschicht D ein Dielektrikum mit hoher relativer Dielektrizitätskonstante εᵣ verwendet werden, wodurch ebenfalls der Platzbedarf für die FPGA-Zelle Z unbeeinflußt bleibt und sich die Schreib/Lese-Spannungen weiter verringern.

Die Erfindung wurde vorstehend anhand von n⁺-dotierten Drain/Source-Gebieten beschrieben. Sie ist jedoch nicht darauf beschränkt und kann in gleicher Weise auf p⁺-dotierte Drain/Source-Gebiete angewendet werden, die sich entsprechend in einem n-Halbleitersubstrat bzw. einer entsprechenden n-Wanne befinden. In gleicher Weise wurde für die erste Isolierschicht SiO₂ vorgeschlagen. Es können jedoch auch andere oder unterschiedliche Isolierschichten für den Schalt-Transistor S-T und den Schreib/Lese-Transistor S/L-T verwendet werden, sofern die grundsätzliche Funktion der Ansteuerung eines darunter liegenden Kanalgebiets sowie das Ermöglichen eines Tunneleffekts sichergestellt ist. Die ladungsspeichernde Schicht und die Steuerschicht wurde vorstehend als Polysiliziumschicht beschrieben, sie sind jedoch nicht darauf beschränkt und umfassen vielmehr alle weiteren ladungsspeichernden Strukturen bzw. leitenden Schichten, mit denen eine FPGA-Zelle mit nichtflüchtigem Halbleiterspeicherelement ausgebildet werden kann.

## Patentansprüche

1. FPGA-Zelle mit
einem gemeinsamen Halbleitersubstrat (1);
einem ersten Drain/Source-Gebiet (D1, S1) zum Ausbilden eines ersten Kanalgebiets (K1) für einen Schalt-Transistor (S-T); wobei das erste Drain/Source-Gebiet (D1, S1) erste Anschlusspunkte (4) und zweite Anschlusspunkte (5) aufweist, die mit Schaltungsknoten externer Logikelemente verbunden sind,
und wobei die Anschlusspunkte (4, 5) die Schaltungsknoten der Logikbauelemente in Abhängigkeit vom Zustand des Schalt-Transistors (S-T) miteinander verbinden oder voneinander trennen, wodurch die Funktionen eines die FPGA-Zelle und die Logikelemente enthaltenden FPGAs anwenderspezifisch eingestellt werden können,
einem zweiten Drain/Source-Gebiet (D2, S2) zum Ausbilden eines zweiten Kanalgebiets (K2) für einen Schreib/Lese-Transistor (S/L-T);
einer gemeinsamen Steuerschichtstruktur (2), die zum gemeinsamen Ansteuern der Transistoren (S-T, S/L-T) über den jeweiligen Kanalgebieten (K1, K2) eine erste Isolierschicht (GO), eine ladungsspeichernde Schicht (FG), eine zweite Isolierschicht (D) und eine Steuerschicht (CG) aufweist; und
einem Isoliergebiet (T_{A}) zum Isolieren der Drain/Source-Gebiete der Transistoren (S-T, S/L-T),
**dadurch gekennzeichnet, dass**
eine Kanalbreite (K_{B}) des ersten Kanalgebiets (K1) im Schalt-Transistor (S-T) kleiner ist als eine Gesamtbreite (G_{B}) des ersten Drain/Source-Gebiets (D1, S1) im Schalt-Transistor (S-T).

2. FPGA-Zelle nach Patentanspruch 1,
**dadurch gekennzeichnet, dass** das erste Drain/Source-Gebiet (D1, S1) H-förmig ausgebildet ist.

3. FPGA-Zelle nach Patentanspruch 1 oder 2,
**dadurch gekennzeichnet, dass** das zweite Drain/Source-Gebiet (D2, S2) L-förmig ausgebildet ist.

4. FPGA-Zelle nach einem der Patentansprüche 1 bis 3,
**dadurch gekennzeichnet, dass** die ladungsspeichernde Schicht (FG) und die Steuerschicht (CG) eine Polysiliziumschicht aufweisen.

5. FPGA-Zelle nach Patentanspruch 3,
**dadurch gekennzeichnet, dass** eine Metallisierung (M1, M2) des zweiten Drain/Source-Gebiets (D2, S2) streifenförmig ausgebildet ist.

6. FPGA-Zelle nach einem der Patentansprüche 1 bis 5,
**dadurch gekennzeichnet, dass** die ladungsspeichernde Schicht (FG) eine ladungsspeichernde Schichtstruktur aufweist.

7. FPGA-Zelle nach einem der Patentansprüche 1 bis 6,
**dadurch gekennzeichnet, dass** die gemeinsame Steuerschichtstruktur (2) über dem Isoliergebiet (T_{A}) eine flächenmäßig unsymmetrische Verbreiterung (8) aufweist.

## Claims

1. FPGA cell having
a common semiconductor substrate (1);
a first drain/source region (D1, S1) for forming a first channel region (K1) for a switching transistor (S-T) ;
where the first drain/source region (D1, S1) has first connection points (4) and second connection points (5) which are connected to circuit nodes of external logic elements,
and where the connection points (4, 5) connect or isolate the circuit nodes of the logic elements to one another or from one another on the basis of the state of the switching transistor (S-T), as a result of which the functions of an FPGA containing the FPGA cell and the logic elements can be set on a user specific basis, a second drain/source region (D1, S2) for forming a second channel region (K2) for a read/write transistor (S/L-T) ;
a common control layer structure (2) which has a first insulating layer (2), a charge-storing layer (FG), a second insulating layer (D) and a control layer (CG) for jointly actuating the transistors (S-T, S/L-T) via the respective channel regions (K1, K2); and
an insulating region (TA) for insulating the drain/source regions of the transistors (S-T, S/L-T),
**characterized in that** a channel width (KB) of the first channel region (K1) in the switching transistor (S-T) is less than a total width (GB) of the first drain/source region (D1, S1) in the switching transistor (S-T).

2. FPGA cell according to patent claim 1,
**characterized in that** the first drain/source region (D1, S1) is formed in the shape of an H.

3. FPGA cell according to patent claim 1 or 2,
**characterized in that** the second drain/source region (D1, S2) is formed in the shape of an L.

4. FPGA cell according to one of patent claims 1 to 3,
**characterized in that** the charge-storing layer (FG) and the control layer (CG) comprise a polysilicon layer.

5. FPGA cell according to patent claim 3,
**characterized in that** a metallized area (M1, M2) of the second drain/source region (D2, S2) is formed in the shape of a strip.

6. FPGA cell according to one of patent claims 1 to 5,
**characterized in that** the charge-storing layer (FG) comprises a charge-storing layer structure.

7. FPGA cell according to one of patent claims 1 to 6,
**characterized in that** the common control layer structure (2) above the insulating region (TA) has a widened portion (8) which has an asymmetrical area.

## Revendications

1. Cellule FPGA comprenant
un substrat (1) semi-conducteur commun ;
une première zone (D1, S1) de drain/source pour constituer une première zone (K1) de canal pour un premier transistor (S-T) de commutation ; la première zone (D1, S1) de drain/source ayant des premiers points (4) de borne et des deuxièmes points (5) de borne, qui sont reliés à des noeuds de circuit d'éléments logiques extérieurs, et dans laquelle les points (4, 5) de borne relient entre eux ou séparent les uns des autres les noeuds de circuit des composants logiques en fonction de l'état du transistor (S-T) de commutation, de sorte que les fonctions d'un FPGA comportant la cellule FPGA et les éléments logiques peuvent être réglées d'une manière spécifique à l'utilisateur,
une deuxième zone (D2, S2) de drain/source pour constituer une deuxième zone (K2) de canal pour un transistor (S/L-T) d'écriture/lecture ;
une structure (2) stratifiée commune de commande qui a, pour commander conjointement les transistors (S-T, S/L-T) par les zones (K1, K2) respectives de canal, une première couche (GO) isolante, une couche (FG) de stockage de charge, une deuxième couche (D) isolante et une couche (CG) de commande ; et
une zone (T_{A}) isolante pour isoler les zones de drain/source des transistors (S-T, S/L-T),
**caractérisée en ce qu'**une largeur (K_{B}) de canal de la première zone (K1) de canal du transistor (S-T) de commutation est plus petite qu'une largeur (G_{B}) totale de la première zone (D1, S1) de drain/source du transistor (St-T) de commutation.

2. Cellule FPGA suivant la revendication 1,
**caractérisée en ce que** la première zone (D1, S1) de drain/source est en forme de H.

3. Cellule FPGA suivant la revendication 1 ou 2,
**caractérisée en ce que** la deuxième zone (D2, S2) de drain/source est en forme de L.

4. Cellule FPGA suivant l'une des revendications 1 à 3,
**caractérisée en ce que** la couche (FG) de stockage de charge et la couche (CG) de commande ont une couche en polysilicium.

5. Cellule FPGA suivant la revendication 3,
**caractérisée en ce qu'**une métallisation (M1, M2) de la deuxième zone (D2, S2) de drain/source est constituée sous la forme de bandes.

6. Cellule FPGA suivant l'une des revendications 1 à 5,
**caractérisée en ce que** la couche (FG) de stockage de charge a une structure stratifiée de stockage de charge.

7. Cellule FPGA suivant l'une des revendications 1 à 6,
**caractérisée en ce que** la structure (2) stratifiée conjointe de commande a, sur la zone (T_{A}) isolante, un élargissement (8) dissymétrique en surface.
